(19)

Europäisches
Patentamt
European
Patent Office
Office européen
des brevets

(11) **EP 2 495 535 A1**

(12) # EUROPEAN PATENT APPLICATION

(43) Date of publication:
**05.09.2012 Bulletin 2012/36**

(51) Int Cl.:
***G01D 4/00*** *(2006.01)*     ***G01R 21/00*** *(2006.01)*
***G01R 23/00*** *(2006.01)*

(21) Application number: **12157684.7**

(22) Date of filing: **01.03.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **03.03.2011 US 201113039445**

(71) Applicant: **General Electric Company
Schenectady, NY 12345 (US)**

(72) Inventors:
• **Runkle, Mark Andrew
Schenectady, NY 12345 (US)**
• **Merola III, John Anthony
Schenectady, NY 12345 (US)**

(74) Representative: **Picker, Madeline Margaret et al
GE International Inc.
Global Patent Operation - Europe
15 John Adam Street
London WC2N 6LU (GB)**

(54) **Wireless monitoring device for electric power grid**

(57)     Disclosed herein is a power consumer approach that monitors the occurrence of grid code events within electric power transmission operations. In one aspect, a grid code event meter (130 or 400) is used to detect the occurrence of a grid code event. The grid code meter (130 or 400) includes a metering component (205, 510 or 515) configured to obtain data for power-related parameters associated with consumption needs. A grid code criteria tracking component (205 or 520) tracks the data related to the power-related parameters obtained by the metering component (205, 510 or 515) for compliance with grid code criteria required by a transmission company of a consumer for power quality and reliability. A grid code event detection component (210 or 520) detects an occurrence of a grid code event in accordance with the tracked data for the power-related parameters. A wireless transmitter (535) is configured to communicate detection of an occurrence of a grid code event with at least one remote computing device (135).

FIG. 1

EP 2 495 535 A1

**Description**

BACKGROUND OF THE INVENTION

The present invention relates generally to electrical power systems and more particularly to monitoring electrical transmission and distribution for the occurrence of severe system upsets called grid code events.

Generally, an electric power system is comprised of generation facilities, consumers and one or more transmission and distribution networks that link them together. The transmission networks are typically owned and controlled by a system operator, who establishes generation standards and guidelines to satisfy the needs of the power consumers. These guidelines are called a grid code. Very severe deviations from normal operation are called grid code events.

Electrical parameters describing a grid code event are typically in frequency and voltage. For example, loss of large nuclear power plants in Florida and Los Angeles, California have resulted in frequency dips from 60 Hz to less than 57 Hz, and severe voltage dips of 40% or more.

Consider another example in 2003 when the northeastern United States of America (USA) experienced a power outage that resulted in a complete fissure or cleavage in the grid from Cleveland, Ohio to New York City, New York. This cleavage of the grid during this power outage resulted in a side with more load than generation. As a result, the side with more load than generation experienced under-frequency and under-voltage. On the other hand, the other side with more generation than load, experienced over-frequency and over-voltage.

BRIEF DESCRIPTION OF THE INVENTION

In one aspect of the present invention, a grid code meter is provided. The grid code meter comprises a metering component configured to obtain data for a plurality of power-related parameters associated with power consumption needs. A grid code criteria tracking component is configured to track the data related to the plurality of power-related parameters obtained by the metering component for compliance with grid code criteria required by a transmission company to satisfy power consumer needs for power quality and reliability. A grid code event detection component is configured to detect an occurrence of a grid code event in accordance with the tracked data being in compliance with the grid code criteria. A wireless transmitter is configured to communicate detection of an occurrence of a grid code event with at least one remote computing device.

BRIEF DESCRIPTION OF THE DRAWINGS

FIG. 1 is a schematic diagram illustrating a system for monitoring the transmission side of an electric power system for the occurrence of a grid code event according to one embodiment of the present invention;

FIG. 2 is a schematic block diagram illustrating further details of a grid code meter depicted in FIG. 1 according to one embodiment of the present invention;

FIG. 3 shows a flow chart illustrating some of the operations performed by the grid code meter depicted in FIGS. 1-2 according to one embodiment of the present invention;

FIG. 4 shows a faceplate of a grid code meter that is suitable for use in residential power consumption applications according to one embodiment of the present invention; and

FIG. 5 shows a more detailed schematic of components that form the grid code meter depicted in FIG. 4 according to one embodiment of the present invention.

DETAILED DESCRIPTION OF EMBODIMENTS OF THE INVENTION

Various embodiments of the present invention are directed to monitoring the transmission side of an electric power system for the occurrence of grid code events by power consumption devices used in industrial, commercial, residential and medical facility applications. In one embodiment, a grid code meter is disclosed that obtains data for a multitude of power-related parameters that are associated with power consumption needs. In one embodiment, the grid code meter tracks the data related to the power-related parameters for compliance with grid code criteria required by a transmission company to satisfy power consumer needs for power quality and reliability. In one embodiment, the grid code meter detects an occurrence of a grid code event if the tracked data for the power-related parameters is not in compliance with the grid code criteria.

The various embodiments of the present invention include technical advantages such as improving monitoring and management of the transmission side of an electric power system. Improved monitoring and management of the transmission side of an electric power system result in increased power quality and reliability for power consumers. For example, power consumers would be able to minimize product losses in a factory. Currently, many factory processes are frequency sensitive, but are unable to afford back-to-back DC conversion to be frequency independent of the grid, or large uninterruptible power supplies for voltage stability, and thus suffer product losses. Grid code detection as provided by the various embodiments of the present invention can allow a power consumer to gracefully trip a process that can be damaged until the meter indicates that the system is nominal.

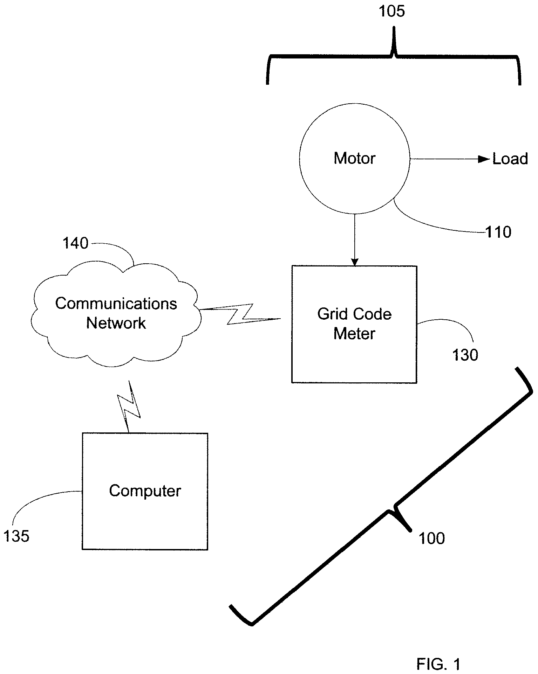

Referring to the drawings, FIG. 1 is a schematic diagram illustrating a system 100 for monitoring the transmission side of an electric power system at a power consumer 105 for the occurrence of a grid code event according to one embodiment of the present invention. In one embodiment, power consumer 105 is an industrial consumer that may have one or more industrial electric motors such as three-phase motors (e.g., induction motors and synchronous motors) driving certain processes. The type of industrial consumer that is suitable for this embodiment is not limited to any particular industry and can range from paper mills to bottling plants to pharmaceutical facilities to any operation where it is desirable to have stable line frequency and voltage. As shown in FIG. 1, power consumer 105 includes a motor 110 such as a three-phase motor that is driving a load (i.e., an operation within the facilities of the consumer). For the sake of illustrating the embodiments of the present invention, only one motor 110 is shown, although those skilled in the art will appreciate that a typical industrial consumer would likely have more motors driving process operations. Furthermore, for ease of illustrating monitoring system 100, only a simplified view of power consumer 105 is provided. Those skilled in the art will recognize that power consumer 105 would include other components and auxiliary equipment in their facilities besides motor 110.

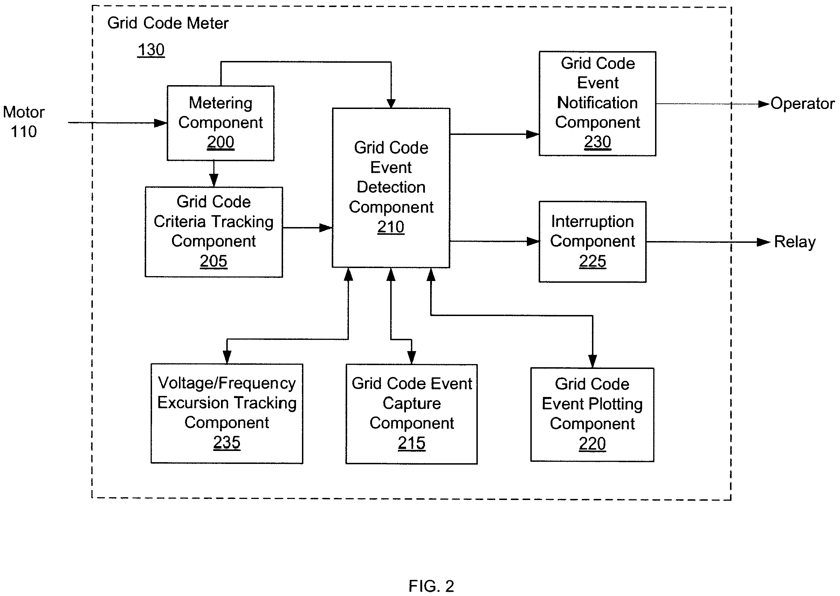

As shown in FIG. 1, monitoring system 100 comprises a grid code meter 130 that nominally functions as a motor control center or motor management relay. Due to its enhanced capability to measure frequency as well as current and voltage, it can sense the characteristic defects in voltage and frequency that define the grid code event. As explained below in more detail with respect to FIG. 2, grid code meter 130 performs a number of functions with regard to detecting an occurrence of a grid code event. These functions include obtaining data from motor 110 that relate to various power-related parameters (e.g., voltage, frequency, current, temperature, etc.), tracking the data for compliance with grid code criteria required by a transmission company to satisfy the consumption needs of power consumer 105 for power quality and reliability, detecting an occurrence of a grid code event if the tracked data for any of the power-related parameters is not in compliance with the grid code criteria.

In addition to performing these functions and others described herein, grid code meter 130 may perform other functions associated with protection of motor 110. These functions may include protecting against items that include unbalanced loads, excessively high over-current faults, under-voltage conditions, over-voltage conditions, mechanical jams and load losses.

Grid code meter 130 may be implemented by configuring a commercially available motor protection device such as an electric meter or relay. One example of a commercially available motor protection device that may be used to configure grid code meter 130 is a 469 Motor Management Relay sold by GE Multilin. Those skilled in the art will recognize that there are other commercially available motor protection devices that perform functions and generate information similar to the 469 Motor Management Relay that can be used to configure grid code meter 130 to perform the functions described in the various embodiments of the present invention. Monitoring system 100 as shown in FIG. 1 further includes a computer 135 that is connected to grid code meter 130 via a communications network 140. Computer 135 can be used to perform one of a variety of operations. For example, computer 135 can be a host computer that is at a remote location that is used by a plant operator to perform remote monitoring and diagnostics of motor 110, as well as other components and auxiliary systems associated with power consumer 105. In one embodiment, computer 135 can be used in the general management of all of the assets in power consumer 105. In another embodiment, computer 130 may be located locally about grid code meter 130, so that a plant operator can have closer interactions with the plant at the process level.

FIG. 2 is a schematic block diagram illustrating further details of grid code meter 130 according to one embodiment of the present invention. As shown in FIG. 2, grid code meter 130 includes a metering component 200 configured to obtain data for a plurality of power-related parameters associated with the power consumption needs of power consumer 105. In one embodiment, the plurality of power related parameters may comprise voltage, current, frequency and temperature. Those skilled in the art will recognize that data of other power related parameters might be monitored such as watts, vars and power factor. Although not illustrated in the figures, various sensors and/or transducers (e.g., voltage sensor, current sensor, phase angle sensor, temperature sensor, etc.) would be located about motor 110 to obtain various measurements. These sensors and/or transducers would be configured to transmit these measurements to metering component 200 of grid code meter 130.

Grid code meter 130 further includes a grid code criteria tracking component 205 configured to track the data related to the plurality of power-related parameters obtained by metering component 200. In particular, grid code criteria tracking component 205 determines if the data for each of the power-related parameters is in compliance with grid code criteria required by the transmission company to satisfy the consumption needs of power consumer 105 for power quality and reliability. In one embodiment, grid code criteria tracking component 205 classifies the obtained data into one of a plurality of classifications specific to a respective power-related parameter. For example, for each power-related parameter (e.g., voltage and frequency) there would be various classifications that correspond to a value of ranges for the data that are representative of certain operating conditions of power consumer 105.

In one embodiment, the classifications specific to frequency may comprise a system nominal classification, a severe low frequency classification, a low frequency classification, a severe high frequency classification and a high frequency classification. Data values that can be grouped into one of these classifications can provide an indication of the status of motor 110. As a result, a plant operator, motor engineer, or process engineer can be notified that motor 110 may be at risk if the frequency data generated therefrom has a troublesome value. In one embodiment, the nominal classification may comprise a frequency ranging from about 59.5 Hz to about 60.5 hertz (Hz), the severe low frequency classification may comprise a frequency less than about 57.8 Hz, the low frequency classification may comprise a frequency ranging from about 57.8 Hz to about 59.5 Hz, the severe high frequency classification may comprise a frequency greater than about 62.2 Hz and the high frequency classification may comprise a frequency ranging from about 60.5 Hz to about 62.2 Hz.

In one embodiment, the classifications specific to voltage (V) may comprise a nominal voltage classification, an extreme under-voltage classification, a severe under-voltage classification, a low voltage classification, an extreme over-voltage classification, a severe over-voltage classification and a high voltage classification. Data values that can be grouped into one of these classifications can provide an indication of the status of motor 110. As a result, a plant operator, motor engineer, or process engineer can be notified that motor 110 may be at risk if the data generated therefrom has a troublesome voltage value. In one embodiment, the nominal voltage classification may comprise a voltage ranging from about 95% to about 105% of a nominal system rating, the extreme under-voltage classification may comprise a voltage less than about 80% V, the severe under-voltage classification may comprise a voltage ranging from about 80% V to about 90% V, the low voltage classification may comprise a voltage ranging from about 90% V to about 95% V, the extreme over-voltage classification may comprise a voltage greater than about 120% V, the severe over-voltage classification may comprise a voltage ranging from about 110% V to about 120% V, and the high voltage classification may comprise a voltage ranging from about 105% V to about 110 % V.

Those skilled in the art will recognize that any number of classifications can be used for each parameter and that embodiments of the present invention are not limited to any specific classification labels. Furthermore, those skilled in the art will recognize that differing data value ranges can be used for each parameter and that embodiments of the present invention are not limited to any specific data ranges.

As shown in FIG. 2, grid code meter 130 further comprises a grid code event detection component 210 configured to detect an occurrence of a grid code event from the tracked data. In particular, grid code event detection component 210 detects the occurrence of a grid code event as a function of the classification of the data into one of the plurality of classifications for the power-related parameters. If the data is classified into any one of the classifications that are indicative of an abnormal condition, then grid code event detection component 210 will determine that power consumer 105 (e.g., motor 110) is not in compliance with the specified grid code criteria.

Grid code event detection component 210 is also configured to make other determinations in addition to grid code event detection. In one embodiment, grid code event detection component 210 determines a ratio of voltage to frequency (V/Hz) in response to detecting the presence of a grid code event. The ratio of voltage to frequency (V/Hz) provides an indication of the severity of over-flux or under-flux of the grid code event. Generally, an over-flux grid code event is characterized by iron core heating of machines on the grid (i.e., motor and generator stators and transformers), while an under-flux grid code event has no deleterious effects.

Grid code meter 130 further includes a grid code event capture component 215 that records the data related to the power-related parameters in response to grid code event detection component 210 determining the occurrence of a grid code event. In one embodiment, grid code event capture component 215 is a digital fault recorder that is configured to automatically capture power-related parameters such as voltage, frequency, and ratio of voltage to frequency (V/Hz) from the instant that a respective low or high level is reached until system 100 determines that power consumer 105 is at a nominal level.

A grid code event plotting component 220 uses the data captured by grid code event capture component 215 to plot a plurality of waveforms describing the grid code event. Waveforms generated by grid code event plotting component 220 may include, for example, off-nominal frequency capability curves, voltage versus time plots that indicate low and high voltage excursions, current, power and var fluctuations. In one embodiment, grid code event plotting component 220 is configured to plot the waveforms describing the grid code event in response to grid code event detection component 210 determining the occurrence of the grid code event. Those skilled in the art will recognize that various time steps can be used to capture appropriately timed spans of certain grid code events.

Grid code meter 130 further includes an interruption component 225 that is configured to disable production of power to motor 110 in response to grid code event detection component 210 determining the occurrence of the grid code event. In one embodiment, interruption component 225 can be configured to trigger the latching of a relay to hold motor 110 in a closed position during any non-zero level for a frequency and/or voltage value. This anticipates a downing event and assumes that the relay is not on an uninterruptible supply. When power is restored to the relay, it will again access the grid. If conditions are normal, then interruption component 225 will disable the relay. In this embodiment, if the grid is still in distress, then the queuing of the relay by interruption component will continue.

Grid code meter 130 as shown in FIG. 2 further includes a grid code event notification component 230 that is configured to generate a notification indicating the occurrence of the grid code event. The notification can be made through one of many different mediums used for reporting information to a plant operator. For example, notification can comprise an alarm, an electronic mail, a report that provides various details of the grid code event such as time of occurrence, location, reason for the event, and actions to take to remedy the event. These are only a non-exhaustive listing of possible forms of notification that may be used, however, embodiments of the present invention are not limited to any particular form of notification.

Those skilled in the art will recognize that grid code meter 130 can perform more functions than those previously described herein with respect to FIG. 2. For instance, grid code meter 130 can have functionality configured to perform functions associated with motor protection of motor 110. These functions may include protecting against items that include unbalanced loads, excessively high overcurrent faults, under-voltage conditions, over-voltage conditions, mechanical jams and load losses. Other components that grid code meter 130 may include are memory for storing data and instructions, communication interfaces, a power supply and various switches.

FIG. 2 further shows that grid code meter 130 includes a voltage and frequency excursion tracking component 235 that is configured to simultaneously track voltage and frequency excursions of motor 110. Like the other components of grid code meter 130, the tracking of voltage and frequency excursions by voltage and frequency excursion tracking component 235 further facilitates in providing information to power consumer 105 that can be used to alert them as to the quality and reliability of the power provided by their transmission company. That is, power consumer 105 can use this information to ascertain whether the transmission company is meeting its obligations under the power agreement that is formed between both parties.

In one embodiment, voltage and frequency excursion tracking component 235 tracks the voltage and frequency of motor 110 for excursions from limits specified by National Electrical Manufacturers Association (NEMA). In particular, NEMA allows for +/- 10% voltage and +/- 5% frequency excursions, where the sum of the two variations may not exceed 10%. Voltage and frequency excursion tracking component 235 simultaneously tracks the voltage and frequency readings obtained from motor 110 for excursions from the above-noted NEMA limits using the following algorithm:

Algorithm:    Vnom = Nominal System Voltage

Fnom = Nominal System Frequency

$Vm$     =     Average of measured line-to-line voltages

$Fm$     =     Measured fundamental system frequency

$|\,X\,|$     =     Absolute value of X

$NV$     =     NEMA Variable

        =     $|\,Vm - Vnom\,| / Vnom * 100 +$

               $|\,Fm - Fnom\,| / Fnom * 100$

create an output variable called NEMA, wherein

NEMA = 0    If NV < 10

NEMA = 1    If NV >= 10

In this embodiment, NEMA = 0 is an indication that the power consumed is within NEMA guidelines for safe motor operation, while NEMA = 1 is an indication that the motor is exposed to abnormal conditions and may sustain thermal damage, either in the stator, rotor or both. Those skilled in the art will appreciate that the NEMA output variable (i.e., NEMA = 0 or NEMA = 1) may be of small interest in the grid of the continental USA, but is of greater interest in second and third world countries where grid code issues are common. The NEMA output variable is also of issue for motor applications where generation is islanded. Examples would be gas pipeline compressor stations, offshore drilling platforms, or other locations where applications are vulnerable to a single or few sources of generation.

In various embodiments of the present invention, portions of grid code meter 130 can be implemented in the form of an entirely hardware embodiment, an entirely software embodiment or an embodiment containing both hardware and software elements. In one embodiment, the processing functions performed by grid code meter 130 may be implemented in software, which includes but is not limited to firmware, resident software, microcode, etc.

Furthermore, the processing functions performed by grid code meter 130 can take the form of a computer program product accessible from a computer-usable or computer-readable medium providing program code for use by or in connection with a computer or any instruction execution system (e.g., processing units). For the purposes of this description, a computer-usable or computer readable medium can be any computer readable storage medium that can contain or store the program for use by or in connection with the computer or instruction execution system.

The computer readable medium can be an electronic, magnetic, optical, electromagnetic, infrared, or semiconductor system (or apparatus or device). Examples of a computer-readable medium include a semiconductor or solid state memory, a random access memory (RAM), a read-only memory (ROM), a rigid magnetic disk and an optical disk. Current examples of optical disks include a compact disk - read only memory (CD-ROM), a compact disk - read/write (CD-R/W) and a digital video disc (DVD).

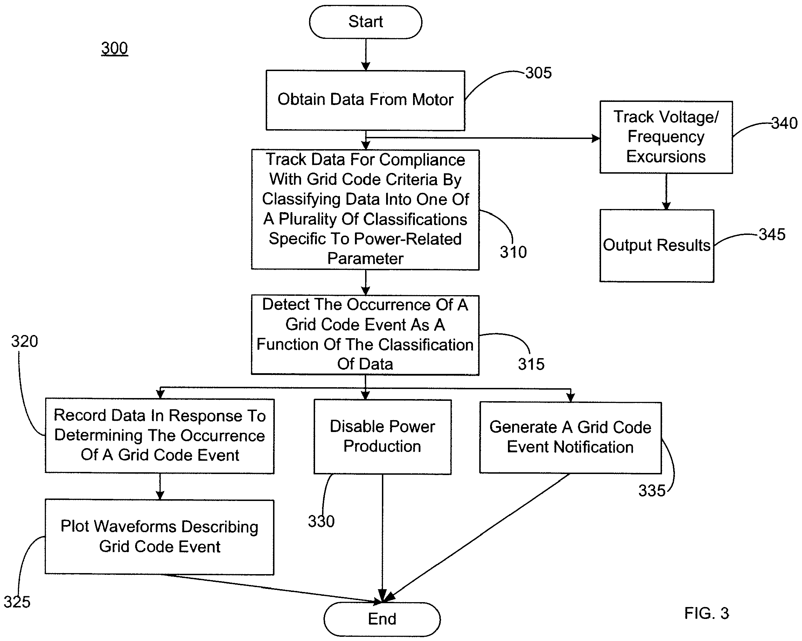

FIG. 3 shows a flow chart 300 illustrating some of the operations performed by grid code meter 130 according to one embodiment of the present invention. Flow chart 300 of FIG. 3 begins by obtaining data for the power-related parameters from motor 110 at 305. In one embodiment, the data may pertain to voltage, current, frequency and temperature and can be measured by one of a number of sensors and/or transducers that are configured to measure such parameters. In one embodiment, grid code meter 130 can obtain the data from the various sensor and/or transducers by any one of currently available electronic communications systems such as Modbus, Prophibus, Foundation Field Bus, Ethernet, etc.

As data is obtained, grid code meter 130 tracks the data related to the power-related parameters at 310 to determine if the data for each of the power-related parameters is in compliance with grid code criteria required by the transmission company of power consumer 105. In one embodiment, this step involves classifying the data into one of a variety of classifications specific to a respective power-related parameter.

Grid code meter 130 via grid code event detection component 210 detects an occurrence of a grid code event from the tracked data at 315. As mentioned above, grid code event detection component 210 detects the occurrence of a grid code event as a function of the classification of the data into one of the plurality of classifications for the power-related parameters. If the data is classified into any one of the classifications that are indicative of an abnormal condition, then grid code event detection component 210 will determine that power consumer 105 (e.g., motor 110) is not in compliance with the specified grid code criteria. Grid code event detection component 210 is also configured to determine a ratio of voltage to frequency (V/Hz) in response to detecting the presence of a grid code event.

Flow chart 300 of FIG. 3 shows that several actions may be taken in response to detecting the occurrence of a grid code event. At 320, grid code meter 130 via grid code event capture component 215 records the data related to the power-related parameters in response to grid code event detection component 210 determining the occurrence of a grid code event. Grid code event plotting component 220 uses the data captured by grid code event capture component 215 to plot a plurality of waveforms describing the grid code event at 325. As mentioned above, waveforms generated by grid code event plotting component 220 may include, for example, off-nominal frequency capability curves, voltage versus time plots that indicate low and high voltage excursions, current, power and var fluctuations.

Another action that may be taken in response to detecting the occurrence of a grid code event includes using interruption component 225 to disable production of power to motor 110 at 330 in response to grid code event detection component 210 determining the occurrence of the grid code event. Once conditions become normal than interruption component 225 can be used to re-establish connection of power to power consumer including motor 110.

The other action shown in FIG. 3 that may be taken in response to detecting the occurrence of a grid code event includes generating a grid code event notification at 335. As mentioned above, examples of notification may include generating an alarm, sending an electronic mail, sending a report providing various details of the grid code event.

Flow chart 300 of FIG. 3 shows that another action may be performed after obtaining data from motor 110. In particular, flow chart 300 includes tracking voltage and frequency readings obtained from motor 110 for excursions from specified limits at 340. As mentioned above, in one embodiment, the voltage and frequency readings may be tracked for excursions from NEMA limits. In this embodiment, the results of the tracking of voltage and frequency excursion are output at 345 to parties that can include motor engineers or process engineers.

The foregoing flow chart of FIG. 3 shows some of the processing functions associated with using grid code meter 130 to detect grid code events in a power consumption device (e.g., motor 110) located at a power consumer 105. In this regard, each block represents a process act associated with performing these functions. It should also be noted that in some alternative implementations, the acts noted in the blocks may occur out of the order noted in the figure or, for example, may in fact be executed substantially concurrently or in the reverse order, depending upon the act involved. Also, one of ordinary skill in the art will recognize that additional blocks that describe the processing functions may be added.

In the embodiments described heretofore, grid code meter 130 was described with respect to a power consumer that is an industrial consumer. Those skilled in the art will appreciate that embodiments described with respect to grid code meter 130 are also suitable for power consumers that include commercial, medical (e.g., hospital) and residential consumers. Like the grid code meter described for industrial consumers, the grid code meter for residential, commercial and medical consumers provides information that indicates the occurrence of grid code events. Instead of grid code events occurring in industrial motors, the grid code events would occur with power consumption devices used in residences, commercial facilities and medical facilities. These power consumption devices could range anywhere from life sustaining medical equipment to simple motor/compressor sets for air condition units. In this embodiment, residential consumers can use information pertaining to the grid code events to alert them on how well their transmission company is meeting grid code criteria specified in their power agreements for power quality and reliability. For medical facilities that normally own backup diesel generator sets for emergency power, it may provide precious time to start this equipment before transfer is required. Typically backup sets respond simply to a loss of power after it is too late. The ability to measure early frequency problems that typically precede voltage collapse provides precious time for precautionary measures.

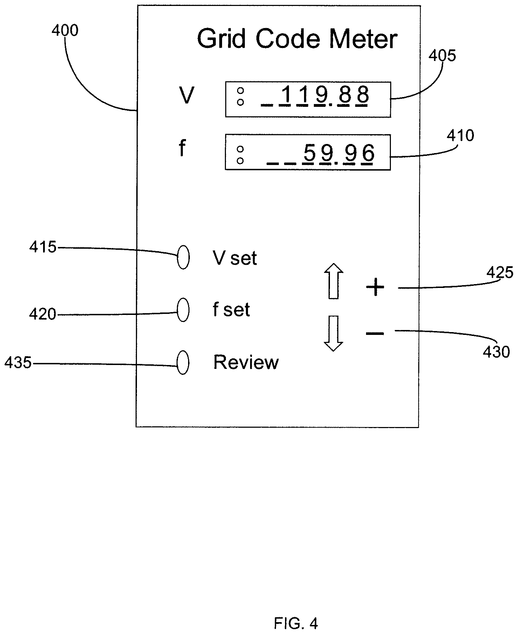

FIG. 4 shows a faceplate of a grid code meter 400 that is suitable for use in residential, commercial and medical power consumption applications according to one embodiment of the present invention. In this embodiment, grid meter 400 would plug into a wall socket. As shown in FIG. 4, the faceplate of grid code meter 400 provides constant readings of voltage (V) and frequency (f) at displays 405 and 410, respectively. In addition, the faceplate of grid code meter 400 provides setting buttons 415 and 420 to allow setting of upper and lower voltage and frequency limits, respectively. Also, the faceplate of grid code meter 400 provides raise/lower buttons 425 and 430 to change the nominal voltage and frequency to the limits, respectively. In addition, the faceplate of grid code meter 400 provides an event review button 435, which when pressed along with voltage or frequency setting buttons 415 and 420, will show the maximum deviation and time of the event in the two windows above. These displays and buttons shown in FIG. 4 serve to warn the power consumers of the quality and reliability of the powder. For example, these displays and buttons of grid code meter 400 could warn a home owner that appliances should simply be shut off rather than endure under-voltage and under-frequency events that could damage air conditioners, refrigerators and sensitive electronics. For well equipped homes and medical facilities, the indication of an event could be used to start emergency generators and separate the facility from the grid entirely.

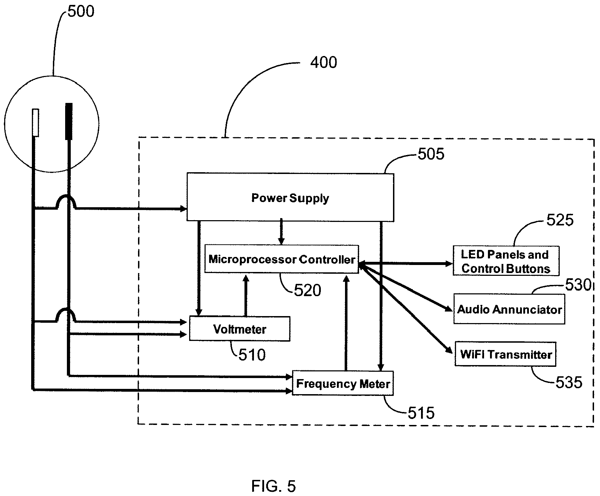

FIG. 5 shows a more detailed schematic of components that form grid code meter 400. As shown in FIG. 5, grid code meter 400 is coupled to a wall socket plug 500 found in a residence, commercial facility or medical facility. Grid code meter 400 includes a power supply 505 that feeds a voltmeter 510, a frequency meter 515 and a microprocessor 520. In one embodiment, power supply 505 may be $V_{dc}$, power supply with a 30 minute backup battery. The backup battery provides two functions. First, it allows grid code meter 400 to be unplugged from wall socket plug 500 for applying specific settings by a consumer. Second, the backup battery of power supply 505 functions to ride through any low voltage ride through event that may occur. In one embodiment, voltmeter 510 and frequency meter 515 may be any commercially available off-the-shelf metering chip. In one embodiment, microprocessor 520 may be any commercially available off-the-shelf microprocessor that can be programmed to read measured voltage and frequency values from meters 510 and 515 and relays to an LED display and control panel 525, capture button presses for commands entered on the faceplate shown in FIG. 4, drive an audio annunciator 530 for alerting consumers and drive relay pickup solenoids for contacts for any external devices that may deployed in the residence.

As discussed for grid code meter 130, grid code meter 400 performs functions such as tracking grid code criteria for determining if the voltage and frequency (power-related parameters) are in compliance with grid code criteria required by the transmission company to satisfy the consumption needs of the residential consumer for power quality and reliability. In addition, grid code meter 400 determines a ratio of voltage to frequency (V/Hz) in response to detecting the presence of a grid code event. In one embodiment, the determined ratio of voltage to frequency (V/Hz) can be displayed on the faceplate of FIG. 4 via LED display and control panel 525. Grid code meter 130 further includes an interruption component 225 that is configured to disable production of power to a particular power consumption device in response to grid code event detection component 210 determining the occurrence of the grid code event. Grid code meter 400 can also be configured to trigger the latching of a relay in a closed position during any non-zero level for a frequency and/or voltage value. In addition, grid code meter 400 can track for voltage and frequency excursion from specified limits. This can be used to alert consumer as to the quality and reliability of the power provided by their transmission company. That is, the residential consumer can use this information to ascertain whether the transmission company is meeting its obligations under their power agreement.

With respect to the functionality of tracking grid code criteria, grid code meter 400 would work in a similar manner described above for grid code meter 130, except the criteria would be different. For example, in one embodiment, the classifications specific to frequency may comprise a system nominal classification, a low frequency classification and a high frequency classification. In one embodiment, the nominal classification may comprise a frequency ranging from about 59.5 Hz to about 60.5 Hz, the low frequency classification may comprise a frequency being less than about 59.5 Hz, and the high frequency classification may comprise a frequency being greater than 60.5 Hz. In one embodiment, the classifications specific to voltage may comprise a nominal voltage classification, a low voltage classification, and an over-voltage classification. In one embodiment, the nominal voltage classification may comprise a voltage that is less or equal to 100% +/- 5%, the low voltage classification may comprise a voltage being less than or equal to about 95% V, and the over-voltage classification may comprise a voltage greater than about 105% V.

Those skilled in the art will recognize that any number of classifications can be used for each parameter and that embodiments of the present invention are not limited to any specific classification labels. Furthermore, those skilled in the art will recognize that differing data value ranges can be used for each parameter and that embodiments of the present invention are not limited to any specific data ranges.

FIG. 5 further shows that grid code meter 400 includes a wireless transmitter 535 for enhancing communication capabilities of the meter. In particular, wireless transmitter 535 can be used to communicate with remote computing devices for remote monitoring and diagnosing of problems and receiving updates, instructions and data, etc. Additional functionality facilitated by wireless transmitter 535 includes the ability to notify an unlimited number of devices within receiving range. As an example, wireless transmitter 535 may be any commercially available off-shelf WiFi transmitter.

While the disclosure has been particularly shown and described in conjunction with a preferred embodiment thereof, it will be appreciated that variations and modifications will occur to those skilled in the art. Therefore, it is to be understood that the appended claims are intended to cover all such modifications and changes as fall within the true spirit of the disclosure.

**Claims**

1. A grid code meter (130 or 400), comprising:

   a metering component (200, 510 or 515) configured to obtain data for a plurality of power-related parameters associated with power consumption needs;
   a grid code criteria tracking component (205 or 520) configured to track the data related to the plurality of power-related parameters obtained by the metering component (200, 510 or 515) for compliance with grid code criteria required by a transmission company to satisfy power consumer needs for power quality and reliability;
   a grid code event detection component (210 or 520) configured to detect an occurrence of a grid code event in accordance with the tracked data being in compliance with the grid code criteria; and
   a wireless transmitter (535) configured to communicate detection of an occurrence of a grid code event with at least one remote computing device (135).

2. The grid code meter (130 or 400) according to claim 1, wherein the wireless transmitter (535) is configured to receive at least one of updates, instructions and data from the at least one remote computing device (135).

3. The grid code meter (130 or 400) according to claim 1, wherein the wireless transmitter (535) is configured to facilitate remote monitoring and diagnostics of the grid code meter (130 or 400) in conjunction with the at least one remote computing device (135).

4. The grid code meter (130 or 400) according to claim 1, wherein the grid code criteria tracking component (205 or 520) is configured to classify the obtained data for the plurality of power-related parameters into one of a plurality of classifications specific to a respective power-related parameter, wherein the plurality of power related parameters preferably comprise frequency and voltage.

5. The grid code meter (130 or 400) according to claim 4, wherein the plurality of classifications specific to frequency comprise a system nominal classification, a low frequency classification and a high frequency classification, wherein the nominal classification comprises a frequency ranging from about 59.5 Hz to about 60.5 Hz, the low frequency classification comprises a frequency being less than about 59.5 Hz, and the high frequency classification comprises a frequency being greater than 60.5 Hz.

**6.** The grid code meter (130 or 400) according to claim 4, wherein the plurality of classifications specific to voltage comprise a nominal voltage classification, a low voltage classification, and an over-voltage classification, wherein the nominal voltage classification comprises a voltage that is less than or equal to 100% +/- 5%, the low voltage classification comprises a voltage being less than or equal to about 95% V, and the over-voltage classification comprises a voltage greater than about 105% V.

**7.** The grid code meter (130 or 400) according to claim 4, further comprising a voltage and frequency excursion tracking component (235 or 520) that tracks the voltage and frequency for excursions from predetermined limits.

**8.** The grid code meter (130 or 400) according to claim 4, wherein the grid code event detection component (210 or 520) detects the occurrence of a grid code event as a function of the classification of the data for the plurality of power-related parameters into one of the plurality of classifications.

**9.** The grid code meter (130 or 400) according to claim 1, wherein the grid code event detection component (210 or 520) is configured to determine a ratio of voltage to frequency (V/Hz) in response to detecting the presence of a grid code event, the ratio of voltage to frequency (V/Hz) providing an indication of severity of over-flux or under-flux of the grid code event.

**10.** The grid code meter (130 or 400) according to claim 1, further comprising a grid code event capture component (215) that is configured to record the data related to the plurality of power-related parameters in response to the grid code event detection component determining the occurrence of the grid code event.

**11.** The grid code meter (130 or 400) according to claim 1, further comprising a grid code event plotting component (220) configured to plot a plurality of waveforms describing the grid code event in response to the grid code event detection component (210 or 520) determining the occurrence of the grid code event.

**12.** The grid code meter (130 or 400) according to claim 1, further comprising an interruption component (225 or 520) that is configured to disable power in response to the grid code event detection component (210 or 520) determining the occurrence of the grid code event.

**13.** The grid code meter (130 or 400) according to claim 1, further comprising a grid code event notification component (230 or 520) configured to generate a notification indicating the occurrence of the grid code event.

**14.** The grid code meter (130 or 400) according to claim 1, wherein the power consumer comprise at least one of an industrial power consumer, residential power consumer, commercial consumer and a medical facility consumer.

**15.** The grid code meter (130 or 400) according to claim 1, further comprising a faceplate having a display panel (405 and 410) to display power related information and a plurality of capture buttons (415, 420, 425, 430 and 435) for inputting commands.

FIG. 1

EP 2 495 535 A1

Grid Code Meter
130

Motor
110

Metering
Component
200

Grid Code
Criteria Tracking
Component
205

Grid Code
Event
Detection
Component
210

Grid Code
Event
Notification
Component
230

Interruption
Component
225

Voltage/Frequency
Excursion Tracking
Component
235

Grid Code Event
Capture
Component
215

Grid Code
Event Plotting
Component
220

Operator

Relay

FIG. 2

FIG. 3

Grid Code Meter

400

V    | ○  _119.88 |    405

f    | ○  __59.96 |    410

415 —— ○ V set

420 —— ○ f set            ⇧  +    425

435 —— ○ Review          ⇩  —    430

FIG. 4

FIG. 5

Europäisches
Patentamt

European
Patent Office

Office européen
des brevets

## EUROPEAN SEARCH REPORT

**Application Number**

EP 12 15 7684

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/101032 A1 (ELSPEC LTD [IL]; NISENBLAT POL [IL]; BROSHI AMIR MORDEHAY [IL]; EFRATI) 27 October 2005 (2005-10-27) * page 8, line 1 - page 9, line 10; figure 1 * | 1-15 | INV. G01D4/00 G01R21/00 G01R23/00 |
| X | WO 2005/064562 A1 (SODIFF E & T CO LTD [KR]; WOOLIM DASYS CO LTD [KR]; JANG WEON-YOUNG [K) 14 July 2005 (2005-07-14) * page 1; claim 2 * | 1,12,14 | |
| X | US 2008/132185 A1 (ELLIOTT KARL E [US] ET AL) 5 June 2008 (2008-06-05) * paragraph [0030]; figure 1 * | 1 | |
| A | US 2003/001747 A1 (GRIFFIN PAUL M [US]) 2 January 2003 (2003-01-02) * abstract; figure 5 * | 12,14 | |

TECHNICAL FIELDS
SEARCHED (IPC)

G01D
G01R

The present search report has been drawn up for all claims

| Place of search | Date of completion of the search | Examiner |
|---|---|---|
| Munich | 31 May 2012 | Flierl, Patrik |

EPO FORM 1503 03.82 (P04C01)

**ANNEX TO THE EUROPEAN SEARCH REPORT
ON EUROPEAN PATENT APPLICATION NO.**

EP 12 15 7684

This annex lists the patent family members relating to the patent documents cited in the above-mentioned European search report.
The members are as contained in the European Patent Office EDP file on
The European Patent Office is in no way liable for these particulars which are merely given for the purpose of information.

31-05-2012

| Patent document cited in search report | | Publication date | Patent family member(s) | | Publication date |
|---|---|---|---|---|---|
| WO 2005101032 | A1 | 27-10-2005 | CN | 101006348 A | 25-07-2007 |
| | | | EP | 1738184 A1 | 03-01-2007 |
| | | | JP | 2007532898 A | 15-11-2007 |
| | | | US | 2006212238 A1 | 21-09-2006 |
| | | | WO | 2005101032 A1 | 27-10-2005 |
| WO 2005064562 | A1 | 14-07-2005 | KR | 20050065860 A | 30-06-2005 |
| | | | WO | 2005064562 A1 | 14-07-2005 |
| US 2008132185 | A1 | 05-06-2008 | US | 2008132185 A1 | 05-06-2008 |
| | | | US | 2012063338 A1 | 15-03-2012 |
| US 2003001747 | A1 | 02-01-2003 | CN | 1549930 A | 24-11-2004 |
| | | | EP | 1405088 A1 | 07-04-2004 |
| | | | US | 2003001747 A1 | 02-01-2003 |
| | | | WO | 03003031 A1 | 09-01-2003 |

EPO FORM P0459